# EUROPEAN PATENT APPLICATION

(11) **EP 4 567 902 A1**
(43) Date of publication of application: **11.06.2025**
(21) Application number: 23848852.2
(22) Date of filing: 22.02.2023
(51) Int. Cl.: H01L 31/0224, H01L 31/0747

(54) **SOLAR CELL AND PREPARATION METHOD THEREFOR**

(30) Priority: 04.08.2022 CN 202210932624
(71) Applicant: TONGWEI SOLAR (HEFEI) CO., LTD., Hefei, Anhui 230088 (CN)
(72) Inventor: YIN, Bingwei, Hefei, Anhui 230088 (CN); YU, Bo, Hefei, Anhui 230088 (CN); ZHOU, Huaming, Hefei, Anhui 230088 (CN); SHI, Gang, Hefei, Anhui 230088 (CN)
(74) Representative: Michalski Hüttermann & Partner Patentanwälte mbB
(86) International application number: PCT/CN2023/077581
(87) International publication number: WO 2024/027137

(57) **Abstract**

The present application provides a solar cell and a preparation method therefor. The solar cell includes: a monocrystalline silicon substrate; an intrinsic amorphous silicon layer disposed on the monocrystalline silicon substrate; a doped amorphous silicon layer disposed on the intrinsic amorphous silicon layer; a transparent conductive film layer disposed on the doped amorphous silicon layer; and an electrode disposed on the transparent conductive film layer and in direct contact with the doped amorphous silicon layer. In the solar cell of the present application, the electrode is not only in contact with the transparent conductive film layer but also in direct contact with the doped amorphous silicon layer. During carrier collection by the electrode, a part of the carriers can be collected in the doped amorphous silicon film layer, which reduces the transfer distance for the carriers in the transparent conductive film layer and decreases the transverse resistance, thereby increasing the photoelectric conversion efficiency of the solar cell.

## Description

### CROSS-REFERENCE TO RELATED APPLICATION

The present application claims the priority of Chinese Patent Application No. 2022109326241, filed with the Chinese Patent Office on August 04, 2022 and entitled "HETEROJUNCTION SOLAR CELL AND PREPARATION METHOD THEREFOR", which is incorporated in its entirety herein by reference.

### TECHNICAL FIELD

The present application relates to the field of photovoltaic technology, in particular to a solar cell and a preparation method therefor.

### BACKGROUND

Due to the photovoltaic effect, photovoltaic cells convert sunlight into electricity by photovoltaic conversion. Early back surface field (BSF) cells suffered from poor passivation due to the high carrier recombination associated with the metallic aluminum film layer on the back surface, resulting in a cell conversion efficiency of only about 19%. By applying dielectric film passivation to the back surface of the cells and utilizing localized metal contact along with backside polishing technology, the back surface recombination rate has been significantly reduced, and light reflection on the back surface has been enhanced. This advancement has led to the development of passivated emitter and rear cell (PERC) structured cells.

Compared to BSF cells and PERC structured cells, heterojunction cells (HJT, also referred to heterojunction with intrinsic thin layer), represent a more efficient type of crystalline silicon solar cell currently. These cells combine the advantages of crystalline silicon cells and silicon-based thin film cells, offering benefits such as a shorter manufacturing process, a lower processing temperature, a relatively high conversion efficiency, and a greater power generation capacity.

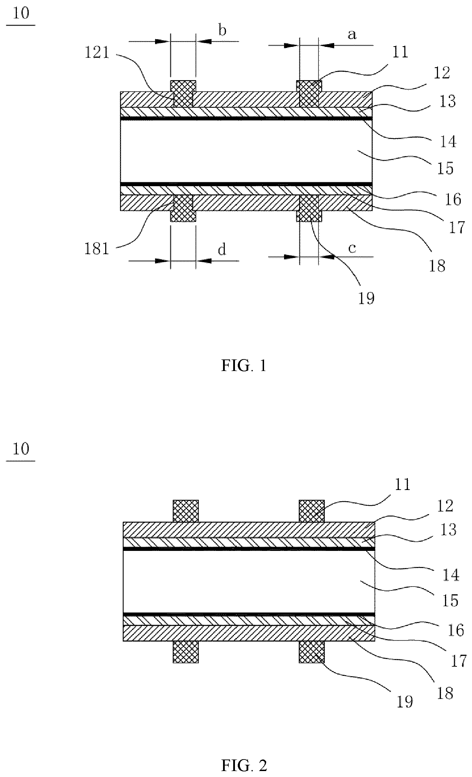

A typical heterojunction cell includes several layers arranged from top to bottom: a front electrode, a front transparent conductive film layer, a front doped amorphous silicon layer, a front intrinsic amorphous silicon layer, a monocrystalline silicon substrate, a back intrinsic amorphous silicon layer, a back doped amorphous silicon layer, a back transparent conductive film layer, and a back electrode. The structure of a conventional heterojunction cell is illustrated in FIG. 2.

In the conventional heterojunction cell, the front electrode contacts the front transparent conductive film layer, while the back electrode contacts the back transparent conductive film layer. During carrier collection by the front and back electrodes, carriers primarily transfer in the front and back transparent conductive film layers. However, the photoelectric conversion efficiency of the heterojunction cell with this structure still requires further improvement.

### SUMMARY

In view of the above, an objective of the present application is to provide a solar cell having a high photoelectric conversion efficiency.

To achieve the above objective, a first aspect of the present application provides a solar cell. The solar cell includes:
a monocrystalline silicon substrate;
an intrinsic amorphous silicon layer disposed on the monocrystalline silicon substrate;
a doped amorphous silicon layer disposed on the intrinsic amorphous silicon layer;
a transparent conductive film layer disposed on the doped amorphous silicon layer; and
an electrode disposed on the transparent conductive film layer and in direct contact with the doped amorphous silicon layer.

In the present application, the electrode is disposed on the transparent conductive film layer and in direct contact with the doped amorphous silicon layer, such that the electrode is not only in contact with the transparent conductive film layer, but also in direct contact with the doped amorphous silicon layer. During carrier collection by the electrode, a part of the carriers can be collected in the doped amorphous silicon film layer, which reduces the transfer distance for the carriers in the transparent conductive film layer and decreases the transverse resistance, thereby increasing the photoelectric conversion efficiency of the solar cell.

In some embodiments, the transparent conductive film layer is provided with a through-hole, and a part of the electrode is embedded in the through-hole and in direct contact with the doped amorphous silicon layer. By forming the through-hole on the transparent conductive film layer and embedding a part of the electrode into the through-hole, the direct contact between the electrode and the doped amorphous silicon layer can be conveniently achieved.

In some embodiments, a width of the through-hole is less than or equal to a width of the part of the electrode that is not embedded in the through-hole. This ensures excellent contact between the electrode and the transparent conductive film layer, thereby decreasing the resistance to the carriers transferred between the transparent conductive film layer and the electrode, and further increasing the photoelectric conversion efficiency of the solar cell.

In some embodiments, the part of the electrode that is embedded in the through-hole is in contact with a side wall of the through-hole. This further ensures excellent contact between the electrode and the transparent conductive film layer, thereby further decreasing the resistance to the carriers transferred between the transparent conductive film layer and the electrode, and further increasing the photoelectric conversion efficiency of the solar cell.

In some embodiments, a ratio of an area of the through-hole to a bottom area of the part of the electrode that is not embedded in the through-hole is (0.94-0.98): 1.

In some embodiments, the through-hole is either a strip-shaped hole or a plurality of dot-shaped holes arranged at intervals.

In some embodiments, the dot-shaped holes include a circular hole, an elliptical hole, a square hole, a rectangular hole, or any combination thereof.

According to a second aspect of the present application, a preparation method for a solar cell is provided. The preparation method includes:
forming an intrinsic amorphous silicon layer on a monocrystalline silicon substrate;
forming a doped amorphous silicon layer on the intrinsic amorphous silicon layer;
forming a transparent conductive film layer on the doped amorphous silicon layer; and
preparing an electrode on the transparent conductive film layer, and making the electrode in direct contact with the doped amorphous silicon layer.

Through the above preparation method, the electrode can be not only in contact with the transparent conductive film layer, but also in direct contact with the doped amorphous silicon layer. During carrier collection by the electrode, a part of the carriers can be collected in the doped amorphous silicon film layer, which reduces the transfer distance for the carriers in the transparent conductive film layer and decreases the transverse resistance, thereby increasing the photoelectric conversion efficiency of the solar cell.

In some embodiments, the forming the transparent conductive film layer on the doped amorphous silicon layer includes: depositing the transparent conductive film layer on the doped amorphous silicon layer by using a mask with a shielding region to form a through-hole for the electrode to be embedded in, at a region of the transparent conductive film layer corresponding to the shielding region. As such, the transparent conductive film layer with a through-hole in a specific shape is deposited and formed on the doped amorphous silicon layer by using the mask with a specific shielding region, such that the electrode can be in direct contact with doped amorphous silicon layer by passing through the through-hole. The preparation method is simple to operate, and the prepared electrode is in excellent contact with the doped amorphous silicon layer, the transparent conductive film layer and inner side wall of the through-hole, thereby further decreasing the resistance and increasing the photoelectric conversion efficiency of the heterojunction cell.

In some embodiments, the method further includes perforating the transparent conductive film layer to form a through-hole for the electrode to be embedded in, in the transparent conductive film layer after the transparent conductive film layer is formed and before the electrode is prepared. As such, the transparent conductive film layer is prepared firstly and then perforated to provide the through-hole for the electrode to be embedded in, which makes the preparation method simple in operation.

In some embodiments, the perforating is performed by solution etching, laser etching, or a combination thereof.

In some embodiments, the preparing the electrode on the transparent conductive film layer includes: printing an electrode paste at the through-hole in the transparent conductive film layer by screen printing, ensuing that the through-hole is filled with the electrode paste, and then solidifying the electrode paste.

In some embodiments, the intrinsic amorphous silicon layer is formed on the monocrystalline silicon substrate through a plasma enhanced chemical vapor deposition method.

In some embodiments, the doped amorphous silicon layer is formed on the intrinsic amorphous silicon layer through a plasma enhanced chemical vapor deposition method.

In some embodiments, the transparent conductive film layer is formed on the doped amorphous silicon layer through a physical vapor deposition method.

In some embodiments, the method further includes: texturing the monocrystalline silicon substrate before the forming the intrinsic amorphous silicon layer on the monocrystalline silicon substrate.

The solar cell of the present application is obtained by modifying the structure of the conventional heterojunction cell so that the electrode of the heterojunction cell is in direct contact with the doped amorphous silicon layer. As such, the electrode can be not only in contact with the transparent conductive film layer, but also in direct contact with the doped amorphous silicon layer. During carrier collection by the electrode, not only the carriers can be transferred into the electrode through the transparent conductive film layer, but a part of the carriers can be collected in the doped amorphous silicon film layer and then transferred into the electrode, which reduce the transfer distance for the carriers in the transparent conductive film layer and reduces the transverse resistance, thereby increasing the photoelectric conversion efficiency of the heterojunction solar cell.

### BRIEF DESCRIPTION OF THE DRAWINGS

For better description and explanation of embodiments and/or examples of the present application, reference may be made to one or more of the accompanying drawings. The additional details or examples used to describe the accompanying drawings should not be taken as limitation of the scope of any of the disclosed application, the presently described embodiments and/or examples, and the presently understood best modes for the application.
FIG. 1 is a schematic structural view of a solar cell according to an embodiment of the present application;
FIG. 2 is a schematic structural view of a conventional solar cell;
FIG. 3 is a schematic view of a carrier transfer direction in the conventional heterojunction cell shown in FIG. 2;
FIG. 4 is a schematic view of a carrier transfer direction in the solar cell according to the embodiment of the present application shown in FIG. 1;
FIG. 5 is a schematic structural view of a transparent conductive film layer with strip-shaped through-holes prepared in the present application;
FIG. 6 is a schematic structural view of a transparent conductive film layer with circular dot-shaped through-holes arranged at intervals prepared in the present application; and
FIG. 7 is a schematic structural view of a transparent conductive film layer with rectangular dot-shaped through-holes arranged at intervals prepared in the present application.

### Description of reference numerals:

10. solar cell; 11. front electrode; 12. front transparent conductive film layer; 13. front doped amorphous silicon layer; 14. front intrinsic amorphous silicon layer; 15. monocrystalline silicon substrate; 16. back intrinsic amorphous silicon layer; 17. back doped amorphous silicon layer; 18. back transparent conductive film layer; 19. back electrode; 121. first through-hole; and 181. second through-hole.

### DETAILED DESCRIPTION OF THE EMBODIMENTS

To facilitate understanding of the present application, the present application will be described more fully hereinafter with reference to the associated accompanying drawings. Preferred embodiments of the present application are shown in the accompanying drawings. However, the present application can be implemented in various different ways and is not limited to the embodiments described herein. It should be understood that these embodiments are provided for a more thorough and comprehensive understanding of contented disclosed in the present application.

Moreover, the terms "first" and "second" are merely for description and cannot be interpreted as indicating or implying relative importance or implicitly indicating the number or order of technical features indicated. Therefore, the features defined with "first" and "second" can explicitly or implicitly include at least one feature. In the description of the present application, "a plurality of" means at least two, such as two or three unless definitely and specifically limited otherwise.

When a positional relation is described, unless otherwise specified, in a case that an element such as a layer, film or substrate is referred to as being "on" another film layer, the element can be directly on the other film layer, or intermediate film layers may be provided. Further, when a layer is referred to as being "below" another layer, the layer may be directly below the other layer, or one or more intermediate layers may be provided. It can also be understood that when a layer is referred to as being "between" two layers, the layer may be the only one between the two layers, or one or more intermediate layers may be provided.

Unless mentioned to the contrary, terms in the singular may include the plural and are not to be construed as one.

Unless defined otherwise, all the technical and scientific terms used herein have the same meaning as those commonly understood by those of ordinary skill in the art to which the present application pertains. The terms used in the description of the present application herein are merely used for describing the specific embodiments and are not intended to limit the present application.

With reference to FIG. 1, some embodiments of the present application provide a solar cell 10. The solar cell 10 includes, in order from a front surface to a back surface, a front electrode 11, a front transparent conductive film layer 12, a front doped amorphous silicon layer 13, a front intrinsic amorphous silicon layer 14, a monocrystalline silicon substrate 15, a back intrinsic amorphous silicon layer 16, a back doped amorphous silicon layer 17, a back transparent conductive film layer 18, and a back electrode 19.

The front electrode 11 is in direct contact with the front doped amorphous silicon layer 13. The back electrode 19 is in direct contact with the back doped amorphous silicon layer 17.

With reference to FIG. 2, in a conventional heterojunction solar cell 10, the front electrode 11 and the back electrode 19 are in contact with the front transparent conductive film layer 12 and the back transparent conductive film layer 18, respectively. During carrier collection by the front electrode 11 and the back electrode 19, the carriers primarily transfer in the front transparent conductive film layer 12 and the back transparent conductive film layer 18.

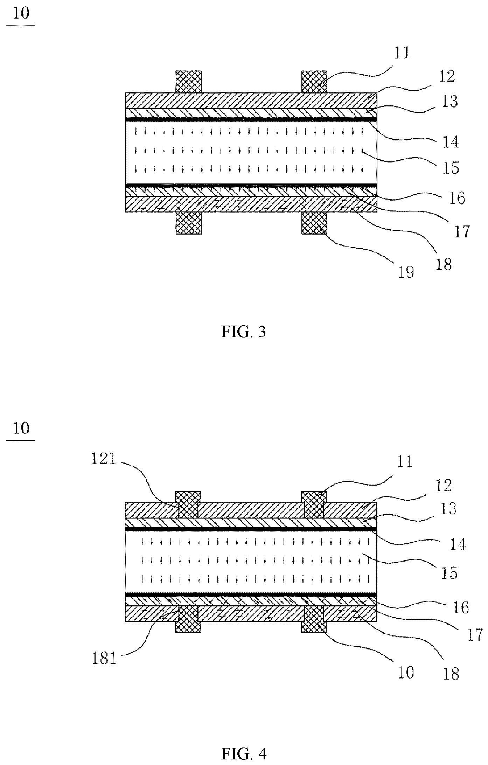

In the solar cell 10 having such a structure, as the carriers primarily transfer in the transparent conductive film layers during carrier collection by the electrodes, a large transverse resistance is generated during carrier collection by the electrodes, resulting in a low photoelectric conversion efficiency of the solar cell 10. A schematic view of a carrier transfer direction in the conventional solar cell 10 is shown in FIG. 3 (a direction indicated by an arrow in FIG. 3 is the carrier transfer direction).

With reference to FIG. 4, to address the above problem, the structure of the conventional solar cell 10 has been modified in the present application so that the front electrode 11 is in direct contact with the front doped amorphous silicon layer 13, while the back electrode 19 is in direct contact with the back doped amorphous silicon layer 17 in the solar cell 10. This allows the electrodes not only to be in contact with the transparent conductive film layers, but also to be in direct contact with the doped amorphous silicon layer. During carrier collection by the electrodes, a part of the carriers can be collected in the doped amorphous silicon film layers, which reduces the transfer distance for the carriers in the transparent conductive film layers and decreases the transverse resistance, thereby increasing the photoelectric conversion efficiency of the solar cell 10.

In a specific embodiment, the front transparent conductive film layer 12 is provided with a first through-hole 121, and a part of the front electrode 11 is embedded in the first through-hole 121 and in direct contact with the front doped amorphous silicon layer 13. Likewise, the back transparent conductive film layer 18 is provided with a second through-hole 181, and a part of the back electrode 19 is embedded in the second through-hole 181 and in direct contact with the back doped amorphous silicon layer 17.

Further, with reference to FIG. 1, a width (*a* in FIG. 1) of the first through-hole 121 is preferably less than or equal to a width (b in FIG. 1) of a part of the front electrode 11 that is not embedded in the first through-hole 121, and the front electrode 11 is in contact with a side wall of the first through-hole 121. A width (c in FIG. 1) of the second through-hole 181 is preferably less than or equal to a width (d in FIG. 1) of a part of the back electrode 19 that is not embedded in the second through-hole 181, and the back electrode 19 is in contact with a side wall of the second through-hole 181. This ensures excellent contact between the front electrode 11 and the front transparent conductive film layer 12 and between the back electrode 19 and the back transparent conductive film layer 18, thereby decreasing the resistance to the carriers transferred between the transparent conductive film layers and the electrodes, and further increasing the photoelectric conversion efficiency of the heterojunction solar cell 10.

In some embodiments, a ratio of an area of the first through-hole 121 to a bottom area of the part of the front electrode 11 that is not embedded in the first through-hole 121 is (0.94-0.98): 1. A ratio of an area of the second through-hole 181 to a bottom area of the part of the back electrode 19 that is not embedded in the second through-hole 181 is (0.94-0.98): 1.

In some specific instances, the first through-hole 121 and the second through-hole 181 may be a strip-shaped hole or a plurality of dot-shaped holes arranged at intervals. Specifically, the dot-shaped holes may be various shapes such as circular holes, elliptical holes, square holes, rectangular holes, etc.

It should be understood that the shapes of the first through-hole 121 and the second through-hole 181 are not limited thereto, and any through-hole can be used as long as the electrode can pass through the transparent conductive film layer to make direct contact with the doped amorphous silicon layer. Moreover, provided that the width of the through-hole is less than or equal to the width of the electrode, the through-hole can be made appropriately wider, which increases the contact area between the electrode and the doped amorphous silicon layer, thereby reducing the resistance during carrier transfer.

It should be noted that in the present application, the specific manner of achieving direct contact between the electrodes and the doped amorphous silicon layers is not limited to the above-mentioned manner of forming the first through-hole 121 and the second through-hole 181 in the front transparent conductive film layer 12 and the back transparent conductive film layer 18. Other conventional manners may also be used to establish contact between the front electrode 11 and the front doped amorphous silicon layer 13 and between the back electrode 19 and the back doped amorphous silicon layer 17.

A preparation method for a solar cell 10 includes S100 to S500.

S100, texturing a monocrystalline silicon substrate 15.

The monocrystalline silicon substrate 15 is firstly textured using a texturing chemical solution to form a pyramidal light-trapping structure on a surface of the monocrystalline silicon substrate 15 to reduce the light reflectance on the monocrystalline silicon substrate 15a and increase the light utilization efficiency of the solar cell 10.

An apparatus and a process for texturing can refer to the conventional texturing and cleaning machines and the conventional texturing procedures.

S200. forming a front intrinsic amorphous silicon layer 14 on a front surface of the monocrystalline silicon substrate 15, and forming a back intrinsic amorphous silicon layer 16 on a back surface of the monocrystalline silicon substrate 15.

Specifically, a plasma enhanced chemical vapor deposition (PECVD) process may be used to deposit the front intrinsic amorphous silicon layer 14 and the back intrinsic amorphous silicon layer 16 on the front surface and the back surface of the monocrystalline silicon substrate 15, respectively.

The specific deposition process conditions for the front intrinsic amorphous silicon layer 14 and the back intrinsic amorphous silicon layer 16 may either follow existing processes or be appropriately adjusted based on existing processes according to actual requirements. The thicknesses of both the front intrinsic amorphous silicon layer 14 and the back intrinsic amorphous silicon layer 16 may be determined according to specific needs.

S300, forming a front doped amorphous silicon layer 13 on the front intrinsic amorphous silicon layer 14, and forming a back doped amorphous silicon layer 17 on the back intrinsic amorphous silicon layer 16.

Specifically, the front doped amorphous silicon layer 13 may be deposited on a surface of the front intrinsic amorphous silicon layer 14 facing away from the monocrystalline silicon substrate 15 through the PECVD process, and the back doped amorphous silicon layer 17 may be deposited on a surface of the back intrinsic amorphous silicon layer 16 facing away from the monocrystalline silicon substrate 15 through the PECVD process.

Likewise, the specific deposition process conditions for the front doped amorphous silicon layer 13 and the back doped amorphous silicon layer 17 may either follow existing processes or be appropriately adjusted based on existing processes according to actual requirements. Thicknesses of both the front doped amorphous silicon layer 13 and the back doped amorphous silicon layer 17 may also be determined according to actual needs.

S400, forming a front transparent conductive film layer 12 on the front doped amorphous silicon layer 13, and forming the back transparent conductive film layer 18 on the back doped amorphous silicon layer 17.

In some embodiments, the front transparent conductive film layer 12 is deposited on a surface of the front doped amorphous silicon layer 13 facing away from the front intrinsic amorphous silicon layer 14 through a physical vapor deposition (PVD) process, and the back transparent conductive film layer 18 is deposited on a surface of the back doped amorphous silicon layer 17 facing away from the back intrinsic amorphous silicon layer 16 through the PVD process.

In a specific embodiment, the front transparent conductive film layer 12 is deposited on the front doped amorphous silicon layer 13 as follows: first, disposing a mask having a shielding region on the front doped amorphous silicon layer 13, and then forming the front transparent conductive film layer 12 on the front doped amorphous silicon layer 13 through the PVD deposition, such that the first through-hole 121 is formed in a region of the front transparent conductive film layer 12 corresponding to the shielding region.

The back transparent conductive film layer 18 is deposited on the back doped amorphous silicon layer 17 as follows: first, forming the back transparent conductive film layer 18 on the back doped amorphous silicon layer 17 through the PVD deposition by using a mask having a shielding region, such that the second through-hole 181 is formed in a region of the back transparent conductive film layer 18 corresponding to the shielding region.

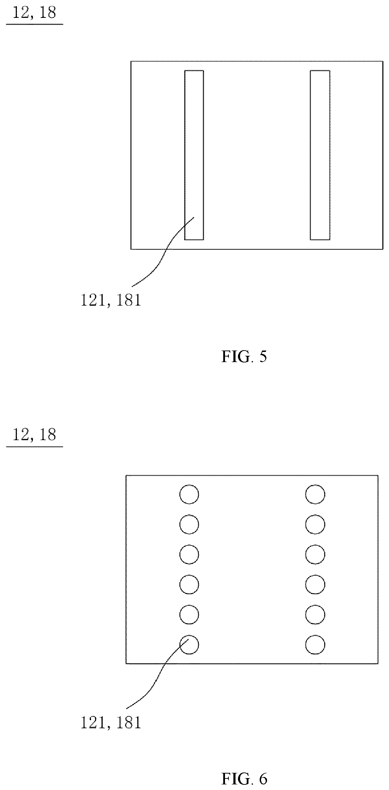

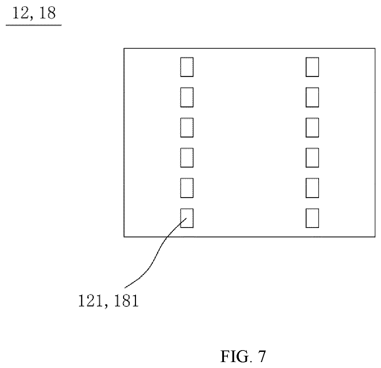

Further, the shape of the shielding region on the mask may be determined according to the shape of the first through-hole 121 or the second through-hole 181. When the first through-hole 121 or the second through-hole 181 is a strip-shaped hole (as shown in FIG. 5), a mask having a strip-shaped shielding region is used. When the first through-hole 121 or the second through-hole 181 includes dot-shaped holes arranged at intervals (as shown in FIGS. 6 and 7), a mask having dot-shaped shielding regions is used.

Through the above method of firstly disposing a mask having a specific shielding region on the doped amorphous silicon layer and then performing PVD deposition to form the transparent conductive film layer, the transparent conductive film layer with a through-hole in a specific shape can be conveniently prepared and formed on the doped amorphous silicon layer. Therefore, the electrode can be conveniently in direct contact with the doped amorphous silicon layer through the through-hole after the subsequent preparation of the electrode.

In some other embodiments, an intact front transparent conductive film layer 12 and an intact back transparent conductive film layer 18 are deposited on the front doped amorphous silicon layer 13 and the back doped amorphous silicon layer 17 through PVD, respectively, and then the first through-hole 121 and the second through-hole 181 having specific shapes are formed at specific positions of the front transparent conductive film layer 12 and the back transparent conductive film layer 18, respectively. Through the above method, corresponding through-holes can also be formed on the transparent conductive film layers.

Specifically, the first through-hole 121 and the second through-hole 181 having specific shapes may be respectively formed in the front transparent conductive film layer 12 and the back transparent conductive film layer 18 by a method such as solution etching or laser.

S500, preparing a front electrode 11 on the front transparent conductive film layer 12 to allow a part of the front electrode 11 to be embedded in the first through-hole 121 in the front transparent conductive film layer 12 and in direct contact with the front doped amorphous silicon layer 13; and preparing a back electrode 19 on the back transparent conductive film layer 18 to allow a part of the back electrode 19 to be embedded in the second through-hole 181 in the back transparent conductive film layer 18 and in direct contact with the back doped amorphous silicon layer 17.

After the front transparent conductive film layer 12 having the first through-hole 121 and the back transparent conductive film layer 18 having the second through-hole 181 are prepared and formed, in the present application, the front electrode 11 is prepared on the front transparent conductive film layer 12 such that a part of the front electrode 11 is embedded in the first through-hole 121 in the front transparent conductive film layer 12 and in direct contact with the front doped amorphous silicon layer 13, and the back electrode 19 is prepared on the back transparent conductive film layer 18 such that a part of the back electrode 19 is embedded in the second through-hole 181 in the back transparent conductive film layer 18 and in direct contact with the back doped amorphous silicon layer 17. The solar cell 10, in which the electrodes are in contact with both the transparent conductive film layers and the doped amorphous silicon layers, can be formed through the above-described method, resulting in a solar cell 10 with a high photoelectric conversion efficiency.

In some embodiments, the front electrode 11 and the back electrode 19 are respectively prepared on the front transparent conductive film layer 12 and the back transparent conductive film layer 18 as follows.

An electrode paste is printed onto a region of the front transparent conductive film layer 12 corresponding to the first through-hole 121 through a screen printing process in a high-precision alignment manner, ensuring that the entire first through-hole 121 is filled with the electrode paste. Once the paste is solidified, the front electrode 11 is formed on the front transparent conductive film layer 12. The front electrode 11 is in direct contact with the front doped amorphous silicon layer 13 through the first through-hole 121.

Likewise, an electrode paste is printed onto a region of the back transparent conductive film layer 18 corresponding to the second through-hole 181 through a screen printing process, ensuring that the entire second through-hole 181 is filled with the electrode paste. Once the paste is solidified, the back electrode 19 is formed on the back transparent conductive film layer 18. The back electrode 19 is direct contact with the back doped amorphous silicon layer 17 through the second through-hole 181.

The first through-hole 121 and the second through-hole 181 can be fully filled with the electrode paste by the screen printing. As a result, after the paste is solidified, the front electrode 11 formed can be in effective contact with both the front doped amorphous silicon layer 13 and the side wall of the first through-hole 121, and the back electrode 19 formed can be in effective contact with both the back doped amorphous silicon layer 17 and the side wall of the second through-hole 181, which further facilitates the carriers to flow into the electrodes simultaneously from the doped amorphous silicon layers and the transparent conductive film layers, thereby further decreasing the resistance and increasing the photoelectric conversion efficiency of the solar cell 10.

In the preparation of the electrode on the transparent conductive film layer by screen printing, preferably, a width of a part of an electrode grid line exposed above the transparent conductive film layer is greater than or equal to the width of the corresponding through-hole (that is, the width of the through-hole is less than or equal to the width of the electrode grid line, as shown in FIG. 1). As such, the electrode grid line can cover an opening of the through-hole, which further increases a contact area between the electrode grid line and the transparent conductive film layer, thereby reducing the resistance.

In general, according to the embodiments of the present application, the structure of the solar cell 10 is modified so that the electrodes of the solar cell 10 pass through the transparent conductive film layers to make direct contact with the doped amorphous silicon layers. In this way, during carrier collection by the electrodes, not only the carriers can be transferred into the electrodes through the transparent conductive film layers, but a part of the carriers can be collected in the doped amorphous silicon film layers and then transferred into the electrodes, which reduces the transfer distance for the carriers in the transparent conductive film layer, thereby reducing the transverse resistance and increasing the photoelectric conversion efficiency of the solar cell 10.

According to the preparation method provided in the embodiments of the present application, the transparent conductive film layers with through-holes in specific shapes are firstly deposited on the doped amorphous silicon layers by using the mask with a specific shielding region through the PVD process, or the transparent conductive film layers are firstly prepared and then formed with the through-holes; and then the electrodes are formed at regions of the transparent conductive film layers corresponding to the through-holes by a screen printing process, such that the electrodes are partially embedded into the through-holes and make direct contact with the transparent conductive film layers. The preparation method is simple to operate, and in the prepared solar cell 10, the electrodes are in excellent contact with the doped amorphous silicon layers, the transparent conductive film layers and inner side walls of the through-holes, thereby further decreasing the resistance and increasing the photoelectric conversion efficiency of the solar cell 10.

The technical features of the above-mentioned embodiments can be combined arbitrarily. In order to make the description concise, not all possible combinations of the technical features are described in the embodiments. However, as long as there is no contradiction in the combination of these technical features, the combinations should be considered as in the scope of the present application.

The above-described embodiments are only several implementations of the present application, and the descriptions are relatively specific and detailed, but they should not be construed as limiting the scope of the present application. It should be understood by those of ordinary skill in the art that various modifications and improvements can be made without departing from the concept of the present application, and all fall within the protection scope of the present application. Therefore, the patent protection of the present application shall be defined by the appended claims.

## Claims

1. A solar cell, comprising:
a monocrystalline silicon substrate;
an intrinsic amorphous silicon layer disposed on the monocrystalline silicon substrate;
a doped amorphous silicon layer disposed on the intrinsic amorphous silicon layer;
a transparent conductive film layer disposed on the doped amorphous silicon layer; and
an electrode disposed on the transparent conductive film layer and in direct contact with the doped amorphous silicon layer.

2. The solar cell according to claim 1, wherein the transparent conductive film layer is provided with a through-hole, and a part of the electrode is embedded in the through-hole and in direct contact with the doped amorphous silicon layer.

3. The solar cell according to claim 2, wherein a width of the through-hole is less than or equal to a width of a part of the electrode that is not embedded in the through-hole.

4. The solar cell according to claim 2 or 3, wherein the part of the electrode that is embedded in the through-hole is in direct contact with a side wall of the through-hole.

5. The solar cell according to any one of claims 2 to 4, wherein a ratio of an area of the through-hole to a bottom area of the part of the electrode that is not embedded in the through-hole is (0.94-0.98): 1.

6. The solar cell according to any one of claims 2 to 5, wherein the through-hole is either a strip-shaped hole or a plurality of dot-shaped holes arranged at intervals.

7. The solar cell according to claim 6, wherein the dot-shaped holes comprise a circular hole, an elliptical hole, a square hole, a rectangular hole, or any combination thereof.

8. A preparation method for a solar cell, comprising:
forming an intrinsic amorphous silicon layer on a monocrystalline silicon substrate;
forming a doped amorphous silicon layer on the intrinsic amorphous silicon layer;
forming a transparent conductive film layer on the doped amorphous silicon layer; and
preparing an electrode on the transparent conductive film layer, and making the electrode in direct contact with the doped amorphous silicon layer.

9. The preparation method for the solar cell according to claim 8, wherein the forming the transparent conductive film layer on the doped amorphous silicon layer comprises:
depositing the transparent conductive film layer on the doped amorphous silicon layer by using a mask with a shielding region to form a through-hole for the electrode to be embedded in, at a region of the transparent conductive film layer corresponding to the shielding region.

10. The preparation method for the solar cell according to claim 8, further comprising: forming a through-hole for the electrode to be embedded in, in the transparent conductive film layer after the transparent conductive film layer is formed and before the electrode is prepared.

11. The preparation method for the solar cell according to claim 10, wherein the through-hole is formed by solution etching, laser etching, or a combination thereof.

12. The preparation method for the solar cell according to any one of claims 9 to 11, wherein the preparing the electrode on the transparent conductive film layer comprises:
printing an electrode paste at the through-hole in the transparent conductive film layer by screen printing, ensuing that the through-hole is filled with the electrode paste, and then solidifying the electrode paste.

13. The preparation method for the solar cell according to any one of claims 8 to 12, wherein the intrinsic amorphous silicon layer is formed on the monocrystalline silicon substrate through a plasma enhanced chemical vapor deposition method.

14. The preparation method for the solar cell according to any one of claims 8 to 13, wherein the doped amorphous silicon layer is formed on the intrinsic amorphous silicon layer through a plasma enhanced chemical vapor deposition method.

15. The preparation method for a solar cell according to any one of claims 8 to 14, wherein the transparent conductive film layer is formed on the doped amorphous silicon layer through a physical vapor deposition method.

16. The preparation method for the solar cell according to any one of claims 8 to 15, further comprising texturing the monocrystalline silicon substrate before the forming the intrinsic amorphous silicon layer on the monocrystalline silicon substrate.
